# EUROPEAN PATENT APPLICATION

(11) **EP 2 843 704 A1**
(43) Date of publication of application: **04.03.2015**
(21) Application number: 14160416.5
(22) Date of filing: 18.03.2014
(51) Int. Cl.: H01L 25/075, F21K 99/00

(54) **Light emitting module and lighting device**

(30) Priority: 29.08.2013 JP 2013178631
(71) Applicant: Toshiba Lighting & Technology Corporation, Yokosuka-shi Kanagawa 237-8510 (JP)
(72) Inventor: Kondo, Kazuya, Kanagawa 237-8510 (JP)
(74) Representative: Bokinge, Ole

(57) **Abstract**

According to one embodiment, there is provided a light emitting module (10) including a plurality of first light emitting elements (121) and a plurality of second light emitting elements (122). The plurality of first light emitting elements (121) and the plurality of second light emitting elements (122) are arranged side by side on a board in a plurality of rows set in advance. Each of the plurality of first light emitting elements (122) is arranged such that, in each of the plurality of rows, the number of the first light emitting elements arranged adjacent to one another is within the number set in advance. Among the plurality of rows, there is a row in which the number of the first light emitting elements (122) arranged adjacent to one another is different from the number in the other rows.

## Description

### FIELD

Embodiments described herein relate to a light emitting module and a lighting device.

### BACKGROUND

In recent years, a lighting device including an LED (Light Emitting Diode) as a light source is spreading. As such a lighting device, there is known a lighting device mounted with a plurality of kinds of LEDs having different light emission colors. In the lighting device, light having a color obtained by mixing the light emission colors of the LEDs is irradiated.

In the lighting device mounted with the plurality of kinds of LEDs having the different light emission colors, in some case, lights having different colors are not mixed and color unevenness occurs on an irradiated surface.

### BRIEF DESCRIPTION OF THE DRAWINGS

FIG. 1 is a diagram showing an example of the configuration of a lighting device mounted with a light emitting module according to an embodiment;
FIG. 2 is a diagram showing an example of the configuration of the light emitting module;
FIG. 3 is a diagram showing an example of electric wiring of the light emitting module;
FIG. 4 is a conceptual diagram for explaining an array of blue LEDs and red LEDs according to the embodiment;
FIG. 5 is a conceptual diagram for explaining emitting directions of lights emitted by the light emitting module; and
FIG. 6 is a conceptual diagram for explaining emitting directions of lights emitted by the light emitting module.

### DETAILED DESCRIPTION

It is an object of the present invention to provide a light emitting module and a lighting device that can reduce color unevenness of light that occurs from an irradiated surface.

According to one embodiment, there is provided a light emitting module including: a plurality of blue LEDs, which are an example of a plurality of first light emitting elements; and a plurality of red LEDs, which are an example of a plurality of second light emitting elements configured to emit lights in a color different from a color of lights emitted by the blue LEDs. The plurality of blue LEDs and the plurality of red LEDs are arranged side by side on a board in a plurality of rows set in advance. Each of the plurality of blue LEDs is arranged such that, in each of the plurality of rows, the number of the blue LEDs arranged adjacent to one another is equal to or smaller than the number set in advance. Among the plurality of rows, there is a row in which the number of the blue LEDs arranged adjacent to one another is different from the number in the other rows. By irregularly arranging the blue LEDs and the red LEDs in this way, it is possible to reduce color unevenness of light emitted by the light emitting module.

In the light emitting module according to the embodiment, the plurality of blue LEDs and the plurality of red LEDs may be arranged in each of a plurality of regions on the board, and the numbers of the arranged blue LEDs and red LEDs may be the same among the regions. The plurality of blue LEDs and the plurality of red LEDs may be arranged in the same arrangement among the regions. Since the plurality of blue LEDs and the plurality of red LEDs are arrayed the same in each of the regions, it is easy to manufacture the light emitting module and it is possible to reduce manufacturing costs.

In the light emitting module according to the embodiment, the plurality of blue LEDs and the plurality of red LEDs in each of the regions may be electrically connected in series.

In the light emitting module according to the embodiment, in each of the regions, there may be a plurality of light emitting element groups including the plurality of blue LEDs continuously connected in series, and, among the plurality of light emitting element groups, there may be a light emitting element group including the different number of the continuously-connected plurality of blue LEDs. Consequently, by arranging, in each of the regions, the plurality of blue LEDs and the plurality of red LEDs connected in series, it is possible to easily create a light emitting module in which the plurality of blue LEDs and the plurality of red LEDs are irregularly arranged as a whole.

The light emitting module according to the embodiment may further include: a wiring pattern provided on the board and configured to supply electric power to each of the plurality of blue LEDs and the plurality of red LEDs; resin, which is a sealing body formed to cover the plurality of blue LEDs and the plurality of red LEDs; and a blocking member configured to surround the resin. At least a part of the blocking member may be disposed on the wiring pattern. Consequently, even when the red LED is arranged at an end of the light emitting module, light emitted by the red LED is reflected on the inner wall of the blocking member and emitted to the outside. Therefore, the light emitting module can efficiently emit the light of the red LED to the outside.

According to another embodiment, there is provided a lighting device including: the light emitting module; and a control section, which is a power-supply control section configured to control a power supply for the light emitting module.

A light emitting module and a lighting device according to an embodiment are explained below with reference to the drawings. In the embodiment, components having the same functions are denoted by the same reference numerals and signs and redundant explanation of the components is omitted. The light emitting module and the lighting device explained in the embodiment are only an example and do not limit the present invention. The embodiments may be combined as appropriate to the extent that the embodiments do not contradict each other. Configuration of a lighting device

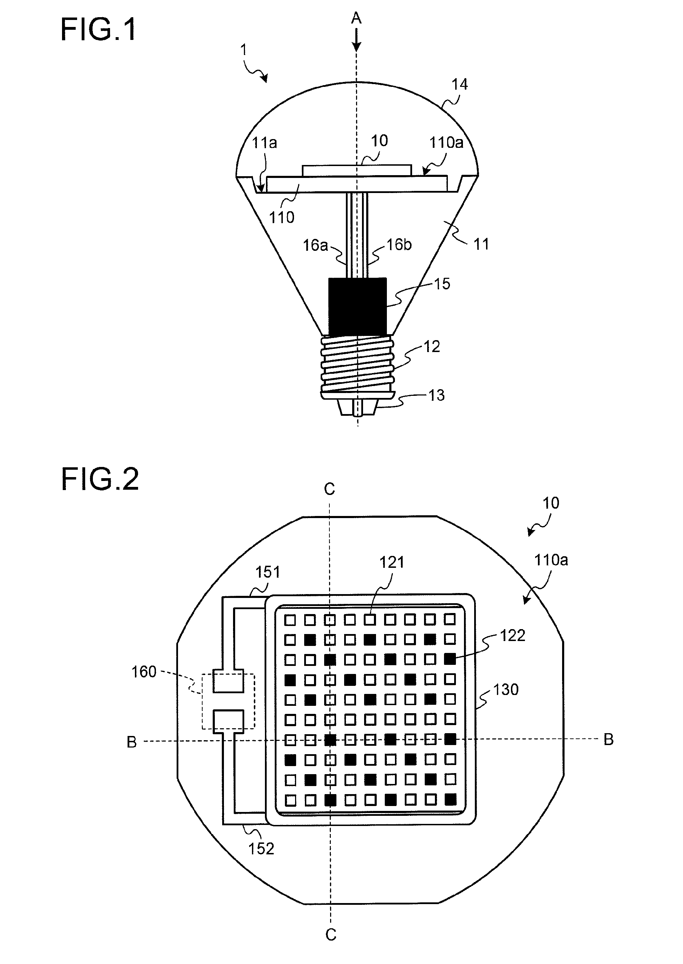

FIG. 1 is a diagram showing an example of the configuration of a lighting device mounted with a light emitting module according to an embodiment. As shown in FIG. 1, a lighting device 1 according to this embodiment includes a light emitting module 10, a main body 11, a cap member 12, an eyelet section 13, a cover 14, a control section 15, an electric wire 16a, and an electric wire 16b. The light emitting module 10 includes a board 110. The board 110 is formed of ceramics having low heat conductivity, for example, alumina, silicon nitride, silicon oxide, or aluminum and arranged on an upper surface 11a of the main body 11.

The main body 11 is formed of metal having high heat conductivity, for example, aluminum in a columnar shape substantially circular in a cross section. The cap member 12 is attached to one end of the main body 11. The cover 14 is attached to the other end of the main body 11. The main body 11 is formed such that the outer circumferential surface of the main body 11 forms a taper surface having a substantially conical shape, the diameter of which sequentially increases in a direction from one end toward the other end.

The main body 11 is formed in an external shape approximate to a silhouette of a neck section in a conventional mini-krypton bulb. On the outer circumferential surface of the main body 11, a not-shown large number of thermal radiation fins radially projecting from one end toward the other end are integrally formed.

The cap member 12 is, for example, an E-type cap of an Edison type. The cap member 12 includes a cylindrical shell made of a cooper plate including a thread ridge. The cap member 12 includes a conductive eyelet section 13 provided at an apex at the lower end of the shell via an electrically insulated section. An opening section of the shell is electrically insulated from and fixed to an opening section at one end of the main body 11.

An input line led out from a power input terminal of a not-shown circuit board in the control section 15 is connected to the shell and the eyelet section 13. The cap member 12 is inserted into a socket provided in, for example, the ceiling to supply electric power, which is supplied from the commercial power supply, to the control section 15.

The cover 14 is formed of, for example, milky-white polycarbonate. The cover 14 is formed in a smooth curved surface shape approximated to a silhouette of a mini-krypton bulb having an opening at one end. An opening end portion of the cover 14 is fit in and fixed to the main body 11 to cover a light emitting surface of the light emitting module 10. A method of fixing the cover 14 to the main body 11 may be any of boning, fitting, screwing, and locking.

The control section 15 supplies electric power to the light emitting module 10 provided on the board 110 and controls lighting and extinction of the light emitting module 10. The control section 15 includes a control circuit housed to be electrically insulated from the outside. The control section 15 converts an alternating-current voltage into a direct-current voltage according to the control by the control circuit and applies the converted direct-current voltage to the light emitting module 10 on the board 110. The electric wires 16a and 16b for supplying electric power to the light emitting module 10 on the board 110 are connected to an output terminal of the control circuit of the control section 15.

The electric wires 16a and 16b are led out to an opening section at the other end of the main body 11 via a not-shown through-hole and a not-shown guide groove formed in the main body 11. Insulation coating is peeled from distal end portions of the electric wires 16a and 16b. The distal end portions are connected to a below-mentioned connector 160 arranged on the board 110.

In this way, the control section 15 supplies electric power, which is input via the shell and the eyelet section 13, to the light emitting module 10 on the board 110 via the electric wires 16a and 16b. The control section 15 collects the electric power, which is supplied to the light emitting module 10, via the electric wires 16a and 16b.

### Configuration of the light emitting module

FIG. 2 is a diagram showing an example of the configuration of the light emitting module according to this embodiment. FIG. 2 is a top view showing an example of the configuration of the light emitting module 10 viewed from an arrow A direction in FIG. 1. As shown in FIG. 2, a plurality of blue LEDs 121 and a plurality of red LEDs 122 are arranged on an arrangement surface 110a of the board 110.

Each of the blue LEDs 121 is a light emitting element configured to emit blue-based light having a peak wavelength within a range of, for example, 445 to 465 nm. Each of the red LEDs 122 is a light emitting element configured to emit red-based light having a peak wavelength within a range of, for example, 590 to 640 nm.

In FIG. 2, one blue LED among the plurality of blue LEDs 121 is denoted by reference numeral "121". However, members indicated by the same white square shape are equivalent to the blue LEDs 121. In FIG. 2, one red LED among the plurality of red LEDs 122 is denoted by reference numeral "122". However, members indicated by the same black square shape are equivalent to the red LED 122.

An annular blocking member 130 is arranged on the arrangement surface 110a of the board 110 to surround the blue LEDs 121 and the red LEDs 122. At least the inner wall of the annular blocking member 130 is formed of a member having a color with high reflectance (e.g., a white color). Alternatively, paint having a color with high reflectance is applied to the inner wall. In a recess formed by the inner wall of the blocking member 130 and the arrangement surface 110a of the board 110, resin including a phosphor is filled.

As the resin, resin obtained by adding a phosphor to transparent resin having high diffusibility such as epoxy resin, urea resin, or silicone resin is used. Each of the blue LEDs 121 and the red LEDs 122 is entirely covered with the resin including such a phosphor from above.

The phosphor added to the resin is excited by the blue-based light emitted by the blue LED 121 and emits light having a color different from a color of the light emitted by the blue LED 121. In this embodiment, a yellow phosphor excited by the blue-based light emitted by the blue LED 121 to emit yellow-based light (a peak wavelength is, for example, 540 to 570 nm), which is in a complementary color relation with the blue-based light, is added to the resin.

Consequently, the light emitting module 10 can emit white light as a whole using the blue-based light emitted by the blue LED 121 and the yellow-based light emitted by the yellow phosphor. Besides the yellow phosphor, a green phosphor excited by the light emitted by the blue LED 121 to emit green-based light may be added to the resin.

Wiring patterns 151 and 152 are formed on the arrangement surface 110a of the board 110. The wiring patterns 151 and 152 are electric conductors printed on the board 110. One end of the wiring pattern 151 and one end of the wiring pattern 152 are connected to the connector 160 provided on the board 110.

As shown in FIG. 2, the other end of the wiring pattern 151 and the other end of the wiring pattern 152 are formed in substantially parallel linear shapes on the arrangement surface 110a of the board 110. At least a part of the other end of the wiring pattern 151 and at least a part of the other end of the wiring pattern 152 are arranged between the arrangement surface 110a of the board 110 and the blocking member 130.

### Wiring in the light emitting module

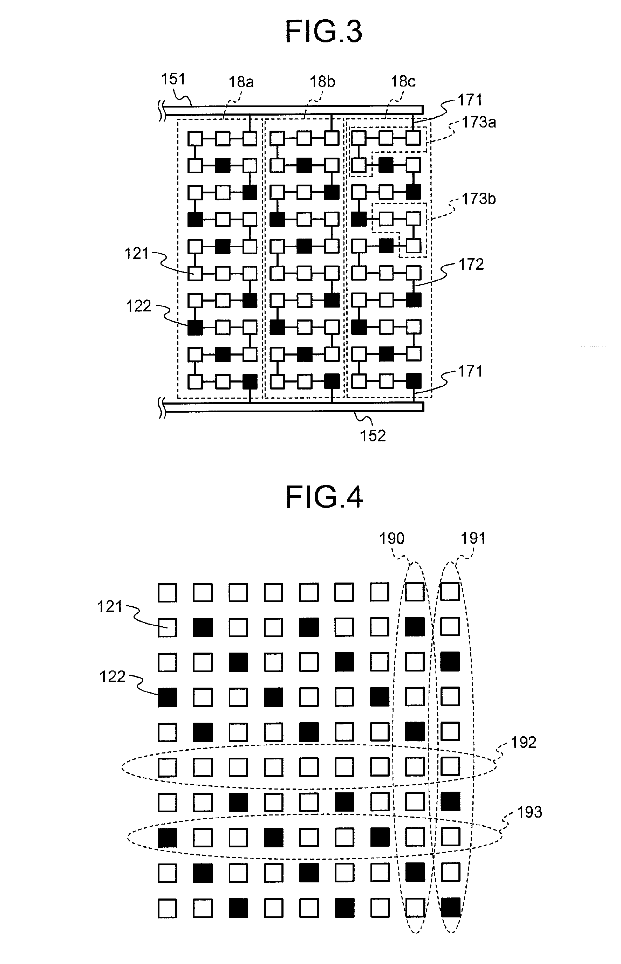

FIG. 3 is a diagram showing an example of electric wiring of the light emitting module according to this embodiment. As shown in FIG. 3, the plurality of blue LEDs 121 and the plurality of red LEDs 122 are arranged in each of a plurality of regions 18a to 18c (in the example shown in FIG. 3, three regions) on the board 110. In each of the regions 18c to 18c, the plurality of blue LEDs 121 and the plurality of red LEDs 122 are connected in series by a bonding wire 172.

In each of the regions 18a to 18c, one end of the plurality of blue LEDs 121 and the plurality of red LEDs 122 connected in series is connected to the other end of the wiring pattern 151, which is formed in a linear shape, by a bonding wire 171. The other end of the plurality of blue LEDs 121 and the plurality of red LEDs 122 connected in series is connected to the other end of the wiring pattern 152, which is formed in a linear shape, by the boding wire 171.

In each of the regions 18a to 18c, the plurality of blue LEDs 121 and the plurality of red LEDs 122 are arranged side by side in a predetermined array on the arrangement surface 110a of the board 110. In the example shown in FIG. 3, the blue LEDs 121 and the red LEDs 122 are arranged side by side in an array of a lattice shape on the arrangement surface 110a of the board 110.

In a state in which the plurality of blue LEDs 121 and the plurality of red LEDs 122 are arranged side by side on the arrangement surface 110a of the board 110, the plurality of blue LEDs 121 and the plurality of red LEDs 122 are arranged such that the number of continuously-arranged LEDs of the same type among the blue LEDs 121 and the red LEDs 122 is within a predetermined number (in the example, shown in FIG. 3, nine) in each of rows of the LEDs.

In each of the rows, the plurality of blue LEDs 121 and the plurality of red LEDs 122 are arranged such that the number of continuously-arranged LEDs of the same type among the blue LEDs 121 and the red LEDs 122 is irregular within the predetermined number. Therefore, among a plurality of rows of the LEDs, there is a row in which the number of the blue LEDs 121 arranged adjacent to one another is different from the number in the other rows.

Among the plurality of regions 18 on the arrangement surface 110a of the board 110, the plurality of blue LEDs 121 and the plurality of red LEDs 122 are arranged such that the number of continuously-arranged LEDs of the same type among the blue LEDs 121 and the red LEDs 122 is irregular within the predetermined number.

In each of the regions 18a to 18c, as shown in FIG. 3, the plurality of blue LEDs 121 and the plurality of red LEDs 122 connected in series are arranged to meander from the wiring pattern 151 to the wiring pattern 152 while being folded back at every predetermined number (in the example shown in FIG. 3, at every three LEDs) along a linear portion of the wiring pattern 151.

In the plurality of blue LEDs 121 and the plurality of red LEDs 122 connected in series in each of the regions 18a to 18c, there is a plurality of light emitting element groups 173 including the plurality of blue LEDs 121 continuously connected in series. Among the plurality of light emitting element groups 173, there is the light emitting element group 173 in which the number of the continuously-connected plurality of blue LEDs 121 is different.

For example, in the example shown in FIG. 3, there are, for example, a light emitting element group 173a and a light emitting element group 173b including the plurality of blue LEDs 121 continuously connected in series in the region 18c. The number of the blue LEDs 121 continuously connected in series in the light emitting element group 173a is four. The number of the blue LEDs 121 continuously connected in series in the light emitting element group 173b is three. In the light emitting element group 173a and the light emitting element group 173b, the numbers of the blue LEDs 121 continuously connected in series are different.

Among the regions 18a to 18c, the plurality of blue LEDs 121 and the plurality of red LEDs 122 are arranged the same. Therefore, the light emitting module 10 can be created by arranging the arrangement in one region 18 to other region 18. Consequently, it is possible to reduce manufacturing costs for the light emitting module 10.

In each of the regions 18a to 18c and among the regions 18a to 18c, the plurality of blue LEDs 121 and the plurality of red LEDs 122 are arranged such that the number of continuously-arranged LEDs of the same type is irregular within a range of the predetermined number. Therefore, in the entire light emitting module 10, the plurality of blue LEDs 121 and the plurality of red LEDs 122 are arranged irregularly. Consequently, the light emitting module 10 can reduce color unevenness due to lights having different colors emitted by the plurality of blue LEDs 121 and the plurality of red LEDs 122.

In each of the regions 18a to 18c, there is a portion where the number of the blue LEDs 121 continuously connected in series is different. Consequently, it is possible to easily realize irregular arrangement by arranging the plurality of blue LEDs 121 and the plurality of red LEDs 122 connected in series to meander.

### Arrangement of the blue LEDs and the red LEDs

FIG. 4 is a conceptual diagram for explaining the array of the blue LEDs and the red LEDs according to this embodiment. For example, as shown in FIG. 4, the blue LEDs 121 and the red LEDs 122 in this embodiment are arranged side by side in an array of a lattice shape on the arrangement surface 110a of the board 110. Besides the lattice shape, the arrangement of the blue LEDs 121 and the red LEDs 122 may be an array of a radial shape, a concentric shape, or a combination of these shapes.

For example, in a row 192 in which the blue LEDs 121 and the red LEDs 122 are arranged side by side in the left right direction in FIG. 4, the number of continuously-arranged blue LEDs 121 is nine. On the other hand, in a row 193 in which the blue LEDs 121 and the red LEDs 122 are also arranged side by side in the left right direction of FIG. 4, the number of the continuously-arranged blue LEDs 121 is two.

For example, in a row 190 in which the blue LEDs 121 and the red LEDs 122 are arranged side by side in the up down direction of FIG. 4, the number of the continuously-arranged blue LEDs 121 is one, two, or three. On the other hand, in a row 191 in which the blue LEDs 121 and the red LEDs 122 are also arranged side by side in the up down direction of FIG. 4, the number of the continuously-arranged blue LEDs 121 is two or three. Further, in the row 190 and the row 191, places where the same numbers of the blue LEDs 121 are continuously arranged are different.

As explained above, the plurality of blue LEDs 121 and the plurality of red LEDs 122 are irregularly arranged on the arrangement surface 110a of the board 110. Therefore, in the entire light emitting module 10, it is possible to reduce color unevenness due to lights having different colors emitted by the plurality of blue LEDs 121 and the plurality of red LEDs 122.

### Positional relation between the red LED and the blocking member

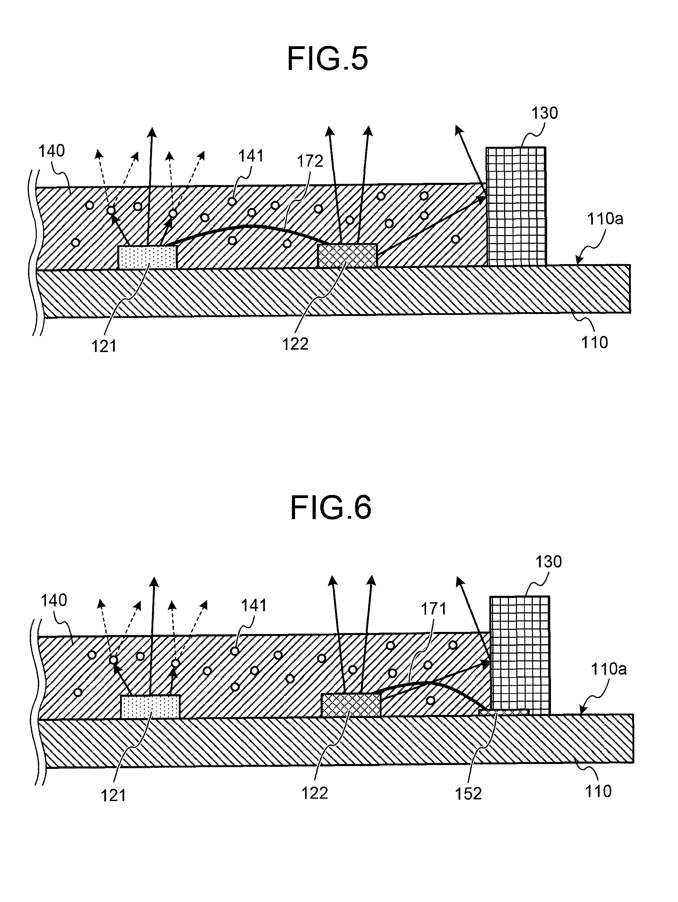

FIG. 5 is a conceptual diagram for explaining emitting directions of lights emitted by the light emitting module according to this embodiment. FIG. 5 is an enlarged view of a part of a B-B section of FIG. 2. Resin 140 includes a yellow phosphor 141. The blue LED 121 emits blue-based light. The yellow phosphor 141 is excited by the light of the blue LED 121 to emit yellow-based light. The light emitting module 10 emits white light as a whole using the blue-based light emitted by the blue LED 121 and the yellow-based light emitted by the yellow phosphor 141.

The red LED 122 emits red-based light. The light emitting module 10 can improve color rendering properties of the white light using the red-based light emitted by the red LED 122.

The blue LED 121 and the red LED 122 emit lights having strong directivity. However, a part of the light emitted by the blue LED 121 is diffused by the yellow phosphor 141. Therefore, when the light is emitted to the outside of the light emitting module 10, the directivity decreases.

On the other hand, the light emitted by the red LED 122 is hardly diffused by the yellow phosphor 141. Therefore, the light is emitted to the outside of the light emitting module 10 while keeping the strong directivity. Therefore, depending on a viewing angle, the light emitted by the red LED 122 weakens and a portion of the light emitting module 10 where the red LED 122 is arranged looks dark. In particular, when the red LED 122 is arranged at an end of a region on the board 110 where the plurality of blue LEDs 121 and the plurality of red LEDs 122 are arranged, the light emitted from the blue LED 121 decreases around the region. Therefore, depending on a viewing angle, the portion looks dark.

Therefore, in the light emitting module 10 in this embodiment, the blocking member 130 is arranged near the region on the board 110 where the plurality of blue LEDs 121 and the plurality of red LEDs 122 are arranged. Consequently, even when the red LED 122 is arranged at the end of the region on the board 110 where the plurality of blue LEDs 121 and the plurality of red LEDs 122 are arranged, a part of the light emitted by the red LED 122 is reflected on the inner wall of the blocking member 130 and emitted to the outside. Therefore, the periphery of the red LED 122 can look brighter.

FIG. 6 is a conceptual diagram for explaining emitting directions of lights emitted by the light emitting module according to this embodiment. FIG. 6 is an enlarged view of a part of a C-C section of FIG. 2. For example, as shown in FIG. 6, in the light emitting module 10 in this embodiment, the blocking member 130 is arranged near the region on the board 110 where the plurality of blue LEDs 121 and the plurality of red LEDs 122 are arranged. As a result, at least a part of the blocking member 130 is arranged on the wiring pattern 152. Although not shown in FIG. 6, on the wiring pattern 151 side, similarly, at least a part of the blocking member 130 is arranged on the wiring pattern 151.

In this embodiment, the plurality of blue LEDs 121 and the plurality of red LEDs 122 are irregularly arranged. Therefore, the red LED 122 is sometimes arranged at the end of the region on the board 110 where the plurality of blue LEDs 121 and the plurality of red LEDs 122 are arranged. However, even in such a case, since the blocking member 130 is arranged near the region on the board 110 where the plurality of blue LEDs 121 and the plurality of red LEDs 122 are arranged, it is possible to prevent the portion of the light emitting module 10 where the red LED 122 is arranged from looking dark.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

## Claims

1. A light emitting module comprising:
a plurality of first light emitting elements; and
a plurality of second light emitting elements configured to emit lights in a color different from a color of lights emitted by the first light emitting elements, wherein
the plurality of first light emitting elements and the plurality of second light emitting elements are arranged side by side on a board in a plurality of rows set in advance,
each of the plurality of first light emitting elements is arranged such that, in each of the plurality of rows, the number of the first light emitting elements arranged adjacent to one another is equal to or smaller than the number set in advance, and
among the plurality of rows, there is a row in which the number of the first light emitting elements arranged adjacent to one another is different from the number in the other rows.

2. The module according to claim 1, wherein
the plurality of first light emitting elements and the plurality of second light emitting elements are arranged in each of a plurality of regions on the board,
the numbers of the arranged first light emitting elements and second light emitting elements are the same among the regions, and
the plurality of first light emitting elements and the plurality of second light emitting elements are arranged in the same arrangement among the regions.

3. The module according to claim 2, wherein the plurality of first light emitting elements and the plurality of second light emitting elements in each of the regions are electrically connected in series.

4. The module according to claim 3, wherein
in each of the regions, there are a plurality of light emitting element groups including the plurality of first light emitting elements continuously connected in series, and
among the plurality of light emitting element groups, there is a light emitting element group including the different number of the continuously-connected plurality of first light emitting elements from other light emitting element group.

5. The module according to claim 4, wherein the plurality of first light emitting elements and the plurality of second light emitting elements connected in series in each of the regions are arranged in a predetermined direction on the board to meander while being folded back at every predetermined number of the light emitting elements.

6. The module according to any one of claims 1 to 5, further comprising:
a wiring pattern provided on the board and configured to supply electric power to each of the plurality of first light emitting elements and the plurality of second light emitting elements;
a sealing body formed to cover the plurality of first light emitting elements and the plurality of second light emitting elements; and
a blocking member configured to surround the sealing body, wherein
at least a part of the blocking member is disposed on the wiring pattern.

7. The module according to claim 6, wherein at least an inner wall of the blocking member is formed of a white member.

8. The module according to claim 6, wherein white paint is applied to at least an inner wall of the blocking member.

9. A lighting device comprising:
the light emitting module according to any one of claims 1 to 8; and
a power-supply control section configured to control a power supply for the light emitting module.
